(19) Europäisches Patentamt / European Patent Office / Office européen des brevets

(11) **EP 4 764 542 A1**

(12) **EUROPEAN PATENT APPLICATION**
published in accordance with Art. 153(4) EPC

(43) Date of publication:
24.06.2026 Bulletin 2026/26

(21) Application number: 24937896.9

(22) Date of filing: 20.11.2024

(51) International Patent Classification (IPC):
$G01R\ 31/392^{(2019.01)}$   $G01R\ 31/396^{(2019.01)}$
$G01R\ 31/382^{(2019.01)}$   $G01R\ 31/52^{(2020.01)}$
$G01R\ 19/00^{(2006.01)}$   $G01R\ 19/165^{(2006.01)}$
$G01R\ 19/10^{(2006.01)}$

(52) Cooperative Patent Classification (CPC):
G01R 19/00; G01R 19/10; G01R 19/165;
G01R 31/382; G01R 31/392; G01R 31/396;
G01R 31/52; Y02E 60/10

(86) International application number:
PCT/KR2024/018406

(87) International publication number:
WO 2025/230072 (06.11.2025 Gazette 2025/45)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: 30.04.2024 KR 20240057663

(71) Applicant: **LG Energy Solution, Ltd.**
**Seoul 07335 (KR)**

(72) Inventors:
• **SUNG, Yong Chul**
**Daejeon 34122 (KR)**
• **CHOI, Won**
**Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT DEVICE AND OPERATING METHOD THEREOF**

(57) A battery management apparatus according to an embodiment disclosed herein includes an interface configured to obtain a plurality of first voltage profiles indicating a voltage change of each of a plurality of battery cells over time and a processor configured to divide the first voltage profile into a plurality of time windows and generate a second voltage profile of each of the plurality of battery cells based on an average variance of a voltage of each of the plurality of battery cells corresponding to each of the plurality of time windows and calculate, based on the second voltage profile, a first voltage parameter related to a deviation between second voltage profile values in adjacent time windows among the plurality of time windows and a second voltage parameter related to a deviation of the second voltage profile value in a same time window among the plurality of time windows to detect whether the plurality of battery cells are abnormal.

```
BATTERY MANAGEMENT APPARATUS
            100
┌──────────────────────────┐
│        INTERFACE         │
│           110            │
└──────────────────────────┘
┌──────────────────────────┐
│        PROCESSOR         │
│           120            │
└──────────────────────────┘
┌──────────────────────────┐
│         MEMORY           │
│           130            │
└──────────────────────────┘
```

FIG.2

**Description**

**TECHNICAL FIELD**

CROSS-REFERENCE TO RELATED APPLICATION

This application claims priority to and the benefit of Korean Patent Application No. 10-2024-0057663 filed in the Korean Intellectual Property Office on April 30, 2024, the entire content of which is incorporated herein by reference.

TECHNICAL FIELD

An embodiment disclosed herein relates to a battery management apparatus and an operating method thereof.

**BACKGROUND ART**

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Secondary batteries gradually degrade through repetitive charging and discharging processes, but it is difficult to accurately predict and detect degradation or defect of the secondary batteries. To predict an abnormal behavior of the secondary battery, characteristics of the secondary battery may be predicted based on an open circuit voltage (OCV) in a rest period of the secondary battery, but it is difficult to accurately detect a cause for the abnormal behavior of the secondary battery based on the OCV in the rest period.

**DISCLOSURE**

**TECHNICAL PROBLEM**

Embodiments disclosed herein aim to provide a battery management apparatus and an operating method thereof in which a cause for an abnormal behavior of a battery cell is diagnosed based on an open circuit voltage (OCV) profile of the battery cell in a rest period.

Technical problems of the embodiments disclosed herein are not limited to the aforementioned technical problems, and other unmentioned technical problems would be clearly understood by those of ordinary skill in the art from the following description.

**TECHNICAL SOLUTION**

A battery management apparatus according to an embodiment disclosed herein includes an interface configured to obtain a plurality of first voltage profiles indicating a voltage change of each of a plurality of battery cells over time and a processor configured to divide the first voltage profile into a plurality of time windows and generate a second voltage profile of each of the plurality of battery cells based on an average variance of a voltage of each of the plurality of battery cells corresponding to each of the plurality of time windows and calculate, based on the second voltage profile, a first voltage parameter related to a deviation between second voltage profile values in adjacent time windows among the plurality of time windows and a second voltage parameter related to a deviation of the second voltage profile value in a same time window among the plurality of time windows to detect whether the plurality of battery cells are abnormal.

According to an embodiment, the processor may be further configured to calculate a first sub voltage parameter indicating the deviation between the second voltage profile values in the adjacent time windows among the plurality of time windows, calculate a second sub voltage parameter indicating a deviation between averages of a plurality of second voltage profile values in the adjacent time windows, and calculate the first voltage parameter indicating a deviation between values obtained by amplifying the first sub voltage parameter and the second sub voltage parameter.

According to an embodiment, the processor may be further configured to detect abnormality of the battery cell based on a result of comparing a product of the first voltage parameter and the second voltage profile value with a preset first reference value and detect that the battery cell is abnormal when the product of the first voltage parameter and the second voltage profile value is greater than the first reference value.

According to an embodiment, the processor may be further configured to obtain a third sub voltage parameter corresponding to an nth maximum value (n is an integer of at least 2) among the plurality of second voltage profile values in each of the plurality of time windows, obtain a fourth sub voltage parameter corresponding to a minimum value among the plurality of second voltage profile values in each of the plurality of time windows, and calculate the second voltage parameter indicating a ratio of a difference between the second voltage profile value and the fourth sub voltage parameter with respect to a difference between the third sub voltage parameter and the fourth sub voltage parameter.

According to an embodiment, the second voltage parameter may be calculated based on

[Equation]

$$Second\ Voltage\ Parameter = \frac{V_2(T) - Min(T)}{max\big(M, (N(T) - Min(T))\big)}$$

in which $V_2(T)$ corresponds to a second voltage profile value in a time window T, $Min(T)$ corresponds to a fourth sub voltage parameter in the time window T, $N(T)$ corresponds to a third sub voltage parameter in the time window T, and $M$ corresponds to a preset threshold value.

According to an embodiment, the processor may be further configured to detect abnormality of the battery cell based on a result of comparing the second voltage parameter with a preset second reference value and detect that the battery cell is abnormal when the second voltage parameter is greater than the second reference value.

According to an embodiment, the second voltage profile may indicate a deviation between average variances of the voltage of each of the plurality of battery cells in adjacent time windows among the plurality of time windows.

An operating method of a battery management apparatus according to an embodiment disclosed herein includes obtaining a plurality of first voltage profiles indicating a voltage change of each of a plurality of battery cells over time, dividing the first voltage profile into a plurality of time windows, generating a second voltage profile of each of the plurality of battery cells based on an average variance of a voltage of each of the plurality of battery cells corresponding to each of the plurality of time windows, calculating, based on the second voltage profile, a first voltage parameter related to a deviation between second voltage profile values in adjacent time windows among the plurality of time windows, calculating a second voltage parameter related to a deviation of the second voltage profile value in a same time window among the plurality of time windows, and detecting whether the plurality of battery cells are abnormal, based on the first voltage parameter and the second voltage parameter.

According to an embodiment, the second voltage profile may indicate a deviation between average variances of the voltage of each of the plurality of battery cells in adjacent time windows among the plurality of time windows.

According to an embodiment, the calculating of the first voltage parameter may include calculating a first sub voltage parameter indicating the deviation between the second voltage profile values in the adjacent time windows among the plurality of time windows, calculating a second sub voltage parameter indicating a deviation between averages of a plurality of second voltage profile values in the adjacent time windows, and calculating the first voltage parameter indicating a deviation between values obtained by amplifying the first sub voltage parameter and the second sub voltage parameter.

According to an embodiment, the detecting of whether the battery cell is abnormal may include multiplying the first voltage parameter and the second voltage profile value and detecting abnormality of the battery cell based on a result of comparing a product of the first voltage parameter and the second voltage profile value with a preset first reference value.

According to an embodiment, the calculating of the second voltage parameter may include obtaining a third sub voltage parameter corresponding to an nth maximum value (n is an integer of at least 2) among the plurality of second voltage profile values in each of the plurality of time windows, obtaining a fourth sub voltage parameter corresponding to a minimum value among the plurality of second voltage profile values in each of the plurality of time windows, and calculating the second voltage parameter indicating a ratio of a difference between the second voltage profile value and the fourth sub voltage parameter with respect to a difference between the third sub voltage parameter and the fourth sub voltage parameter.

According to an embodiment, the second voltage parameter may be calculated based on

[Equation 1]

$$Second\ Voltage\ Parameter = \frac{V_2(T) - Min(T)}{max(M, (N(T) - Min(T)))}$$

wherein $V_2(T)$ corresponds to a second voltage profile value in a time window T, $Min(T)$ corresponds to a fourth sub voltage parameter in the time window T, $N(T)$ corresponds to a third sub voltage parameter in the time window T, and $M$ corresponds to a preset threshold value.

According to an embodiment, the detecting of abnormality of the battery cell may include detecting abnormality of the battery cell based on a result of comparing the second voltage parameter with a preset second reference value.

## ADVANTAGEOUS EFFECTS

A battery management apparatus according to an embodiment disclosed herein may effectively detect a tab short-circuit of a battery cell.

The effects according to an embodiment disclosed in the present document are not limited to the effects mentioned above, and other effects not mentioned will be clearly understood by those of ordinary skill in the art according to the disclosure of the present document.

## DESCRIPTION OF DRAWINGS

FIG. 1 is a view for describing a battery pack according to an embodiment disclosed herein.
FIG. 2 is a view for describing a battery management apparatus according to an embodiment disclosed herein.
FIG. 3 is a view for describing a first voltage profile according to an embodiment disclosed herein.
FIG. 4 is a view for describing a process of generating a second voltage profile according to an embodiment disclosed herein.
FIG. 5 is a view for describing a second voltage profile according to an embodiment disclosed herein.
FIG. 6 is a flowchart for describing an operation of a battery management apparatus according to an embodiment disclosed herein.
FIG. 7 is a view for describing a computing system having mounted thereon a battery management apparatus according to an embodiment disclosed herein.

## MODE FOR INVENTION

Hereinafter, embodiments disclosed herein will be described in detail through exemplary drawings. In adding reference numerals to components of each drawing, it should be noted that the same components have the same numerals as much as possible even though they are displayed on different drawings. Moreover, in describing the embodiments disclosed herein, when it is determined that a detailed description of a related known configuration or function interferes with understanding of the embodiment disclosed herein, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. The terms defined in a generally used dictionary should be interpreted as having the same meanings as the contextual meanings of the relevant technology and should not be interpreted as having ideal or exaggerated meanings unless they are clearly defined in the present application.

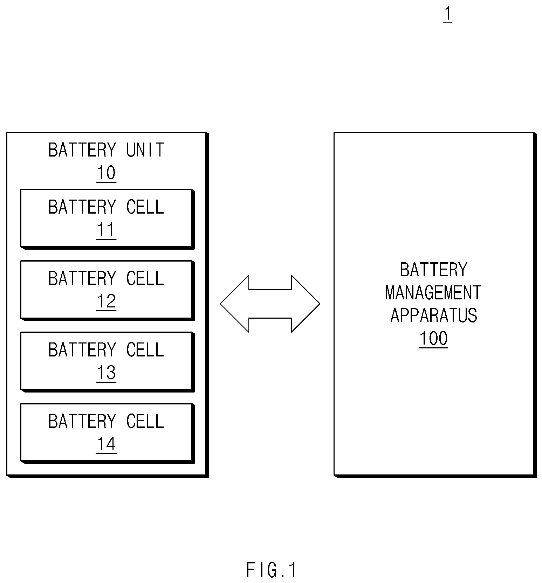

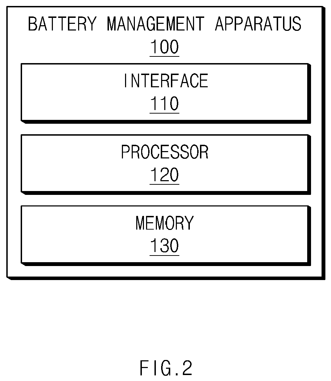

FIG. 1 is a view for describing a battery pack according to an embodiment disclosed herein, and FIG. 2 is a view for describing a battery management apparatus according to an embodiment disclosed herein.

Referring to FIG. 1 first, a battery pack 1 may include a battery unit 10 and a battery management apparatus 100.

The battery unit 10 may include a plurality of battery cells 11, 12, 13, and 14. Although it is shown in FIG. 1 that the battery unit 10 includes four battery cells, the present disclosure is not limited thereto, and the battery unit 10 may include n battery cells (n is a natural number of at least 2).

The plurality of battery cells 11, 12, 13, and 14 may be a lithium ion (Li-ion) battery, an Li-ion polymer battery, a nickel-cadmium (Ni-Cd) battery, a nickel hydrogen (Ni-MH) battery, etc., and are not limited thereto. While it is shown in FIG. 1 that the battery pack 1 includes one battery unit 10, the battery pack 1000 may include n battery units (n is a natural number of at least 2) according to an embodiment. According to an embodiment, the battery unit 10 may be implemented with, but not limited to, a battery module, a battery pack, and/or a battery rack, etc.

The battery unit 10 may be included in the battery pack 1 to supply power to a target device (not shown). To this end, the battery pack 1 may be electrically connected to the target device. Herein, the target device may include an electric, electronic, or mechanical integral device operating with power supplied from the battery pack 1, and for example, the target device may be, but not limited to, an electric vehicle (EV), a two-wheeled electric vehicle such as an electric scooter, etc. When the target device is a two-wheeled electric vehicle such as the electric scooter, etc., the battery pack 1 mounted on the two-wheeled electric vehicle may be replaced through a battery swapping station (BSS).

The battery management apparatus 100 may manage and/or control a state and/or an operation of the battery unit 10. For example, the battery management apparatus 100 may manage and/or control the states and/or operations of the plurality of battery cells 11, 12, 13, and 14 included in the battery unit 10 or manage charging and/or discharging of the battery unit 10.

The battery management apparatus 100 may monitor voltage, current, temperature, etc., of the battery unit 10 and each of the plurality of battery cells 11, 12, 13, and 14. To this end, a sensor or various measurement units not shown in FIG. 1 may be further installed at an arbitrary position, in a charging/discharging path, etc., in the battery unit 10 or the battery pack 1.

The battery management apparatus 100 may calculate a parameter indicating a state of the battery unit 100, e.g., a state of charge (SOC), a state of health (SOH) etc., based on a measurement value such as the monitored voltage, current, temperature, etc.

The battery management apparatus 100 may be configured to diagnose degradation degrees of the plurality of battery cells 11, 12, 13, and 14 and/or detect a battery cell having abnormality occurring therein among the plurality of battery cells 11, 12, 13, and 14. A matter related thereto will be described in a description of FIG. 2.

Referring to FIG. 2, the battery management apparatus 100 may include an interface 110, a processor 120, and a memory 130.

The interface 110 may obtain a first voltage profile of each of the plurality of battery cells 11, 12, 13, and 14 (see FIG. 1). Herein, the first voltage profile may include, but not limited to, a graph, etc., indicating a voltage change of each of the plurality of battery cells 11, 12, 13, and 14 over time. The interface 110 may measure and/or predict a voltage of each of the plurality of battery cells 11, 12, 13, and 14 based on current and/or internal resistance flowing through the battery pack 1 (see FIG. 1).

According to an embodiment, the interface 110 may apply voltage and/or current to the plurality of battery cells 11, 12, 13, and 14 to obtain the first voltage profile. In this case, the interface 110 may include various circuits for applying voltage and/or current to the plurality of battery cells 11, 12, 13, and 14, a processor for computing and/or processing a first voltage profile obtained, etc.

According to an embodiment, the interface 110 may indirectly obtain the first voltage profile of each of the plurality of battery cells 11, 12, 13, and 14. In this case, the interface 110 may further include a communication module, etc., for wiredly and/or wirelessly communicating with the battery pack 1.

According to an embodiment, the interface 110 may obtain the first voltage profile of the plurality of battery cells 11, 12, 13, and 14 each time when state of charge (SOC) of each of the plurality of battery cells 11, 12, 13, and 14 reaches a preset threshold value. Herein, the preset threshold value may be, but not limited to, 100 % or 0 % indicating a state where charging is completed and/or discharging completed. The interface 110 may obtain the first voltage profile indicating a voltage change of each of the plurality of battery cells 11, 12, 13, and 14 over time from a point in time when charging and/or discharging of each of the plurality of battery cells 11, 12, 13, and 14 is completed.

According to an embodiment, the interface 110 may obtain the first voltage profile of each of the plurality of battery cells 11, 12, 13, and 14 until a voltage of each of the plurality of battery cells 11, 12, 13, and 14 reaches a rest voltage.

The processor 120 may control overall operations of the battery management apparatus 100. Herein, the processor may execute software to control an operation of at least one other component (e.g., hardware or software) of the battery management apparatus 100 or perform operations such as processing and/or calculating various data, etc. Referring to FIG. 2, it is shown that the battery management apparatus 100 includes one processor 120, but the present disclosure is not limited thereto and the battery management apparatus 100 may include at least one processor.

The processor 120 may be configured to detect a battery cell having abnormality occurring therein among the plurality of battery cells 11, 12, 13, and 14, based on the first voltage profile of each of the plurality of battery cells 11, 12, 13, and 14. The processor 120 may calculate various voltage parameters for detecting abnormality of the plurality of battery cells 11, 12, 13, and 14 based on the first voltage profile of each of the plurality of battery cells 11, 12, 13, and 14, and to this end, may generate a second voltage profile of each of the plurality of battery cells 11, 12, 13, and 14 based on the first voltage profile.

According to an embodiment, the processor 120 may divide the first voltage profile of each of the plurality of battery cells 11, 12, 13, and 14 into a plurality of time windows. Herein, a length of each time window may be the same as or different from each other, and is not limited to a specific example.

The processor 120 may generate the second voltage profile of each of the plurality of battery cells 11, 12, 13, and 14 based on the first voltage profile of each of the plurality of battery cells 11, 12, 13, and 14 in each of the plurality of time windows. According to an embodiment, the second voltage profile may be related to, but not limited to, an average variance of a voltage of each of the plurality of battery cells 11, 12, 13, and 14 in each of the plurality of time windows.

According to an embodiment, the processor 120 may calculate an average variance of a cell voltage of each of the plurality of battery cells 11, 12, 13, and 14 in each of the plurality of time windows based on the first voltage profile. The processor 120 may compute the average variance by dividing the variance of the voltage of each of the plurality of battery cells 11, 12, 13, and 14 by the length of the time window in each of the plurality of time windows.

According to an embodiment, the processor 120 may calculate an average voltage of the plurality of battery cells 11, 12, 13, and 14 in each of the plurality of time windows and calculate an average variance of the average voltage of the plurality of battery cells 11, 12, 13, and 14 in each of the plurality of time windows. The processor 120 may calculate the average voltage of the plurality of battery cells 11, 12, 13, and 14 and calculate the average variance of the average voltage by dividing the variance of the average voltage in each of the plurality of time windows by the length of the time window.

According to an embodiment, the processor 120 may calculate a deviation between the average variance of each of the plurality of battery cells 11, 12, 13, and 14 in each of the plurality of time windows and the average variance of the average voltage of the plurality of battery cells 11, 12, 13, and 14. For example, the processor 120 may calculate a deviation between an average variance of a voltage of the battery cell 11 in each of the plurality of time windows and an average variance of an average voltage of the plurality of battery cells 11, 12, 13, and 14, calculate a deviation between an average variance of a voltage of the battery cell 12 and the average variance of the average voltage of the plurality of battery cells 11, 12, 13, and 14, calculate a deviation between an average variance of a voltage of the battery cell 13 and the average variance of the average voltage of the plurality of battery cells 11, 12, 13, and 14, and calculate a deviation between an average variance of a voltage of the battery cell 14 and the average variance of the average voltage of the plurality of battery cells 11, 12, 13, and 14.

The processor 120 may calculate a difference between deviations between the average variance of the voltage of each of the plurality of battery cells 11, 12, 13, and 14 in an adjacent time window among the plurality of time windows and the average variance of the average voltage. Herein, the adjacent time window may be a time window of either a preceding time window and/or a following time window, and is not limited to a specific example. For example, when the most preceding time window is a first time window and a time window following the first time window is a second time window among the plurality of time windows, the processor 120 may calculate a difference between a deviation between the average variance of the voltage of the first battery cell 11 and the average variance of the average voltage of the plurality of battery cells 11, 12, 13, and 14 in the second time window and a deviation between the average variance of the voltage of the first battery cell 11 and the average variance of the average voltage of the plurality of battery cells 11, 12, 13, and 14 in the first time window. The processor 120 may calculate a difference between a deviation between the average variance of the voltage of the first battery cell 11 and the average variance of the average voltage of the plurality of battery cells 11, 12, 13, and 14 in a third time window following the second time window and a deviation between the average variance of the voltage of the first battery cell 11 and the average variance of the average voltage of the plurality of battery cells 11, 12, 13, and 14 in the second time window, and this process may be repeated until a difference for all of the plurality of time windows is calculated and a difference for each of the plurality of battery cells 11, 12, 13, and 14 is calculated.

The processor 120 may generate a second voltage profile for each of the plurality of battery cells 11, 12, 13, and 14 based on a difference between deviations between the average variance of the voltage of each of the plurality of battery cells 11, 12, 13, and 14 in an adjacent time window among the plurality of time windows and the average variance of the average voltage of the plurality of battery cells 11, 12, 13, and 14. Herein, the second voltage profile may include, but not limited to, a graph, etc., indicating a difference between the deviations between the average variance of the voltage of each of the plurality of battery cells 11, 12, 13, and 14 and the average variance of the average voltage of the plurality of battery cells 11, 12, 13, and 14 over time.

The processor 120 may calculate a first voltage parameter and a second voltage parameter for detecting abnormality of the plurality of battery cells 11, 12, 13, and 14 based on the second voltage profile of each of the plurality of battery cells 11, 12, 13, and 14. According to an embodiment, the first voltage parameter may be related to a difference between second voltage profile values of each of the plurality of battery cells 11, 12, 13, and 14 in adjacent time windows among the plurality of time windows, and the second voltage parameter may be related to, but not limited to, a deviation of the second voltage profile value of each of the plurality of battery cells 11, 12, 13, and 14 in the same time window among the plurality of time windows.

Specifically, the processor 120 may calculate a first sub voltage parameter and a second sub voltage parameter for calculating the first voltage parameter. Herein, the first sub voltage parameter may include data related to the deviation between the second voltage profiles of each of the plurality of battery cells 11, 12, 13, and 14 in adjacent time windows among the plurality of time windows. For example, the most preceding time window is a first time window and a time window following the first time window is a second time window, the processor 120 may calculate a deviation between a second voltage profile value of the first battery cell 11 in the second time window and a second voltage profile value of the first battery cell 11 in the first time window to calculate the first sub voltage parameter. Likewise, the processor 120 may calculate a deviation between the second voltage profile value of the first battery cell 11 in the third time window following the second time window and the second voltage profile value of the first battery cell 11 in the second time window to calculate the first sub voltage parameter, and this process may be repeated until the first sub voltage parameter is calculated for all of the plurality of time windows. The processor 120 may calculate the first sub voltage parameter based on the second voltage profile of each of the second battery cell 12, the third battery cell 13, and the fourth battery cell 14 as well as the first battery cell 11.

The processor 120 may also generate a second average voltage profile indicating an average of the second voltage profile value of each of the plurality of battery cells 11, 12, 13, and 14.

The processor 120 may calculate the second sub voltage parameter based on the generated second average voltage profile. Herein, the second sub voltage parameter may include, but not limited to, data related to a difference between second average voltage profile values in adjacent time windows among the plurality of time windows. For example, the processor 120 may calculate the second sub voltage parameter by calculating a deviation between the second average voltage profile value in the second time window and the second average voltage profile in the first time window, and calculate the second sub voltage parameter by calculating a deviation between the second average voltage profile value in the third time window and the second average voltage profile value in the second time window. This process may be repeated until the second sub voltage parameter is calculated for all of the plurality of time windows.

The processor 120 may calculate the first voltage parameter based on the calculated first sub voltage parameter and second sub voltage parameter. According to an embodiment, the first voltage parameter may include, but not limited to, data related to a difference between a value obtained by amplifying the first sub voltage parameter by an amplification coefficient and a value obtained by amplifying the second sub voltage parameter by an amplification coefficient in a corresponding time window among the plurality of time windows.

According to an embodiment, the amplification coefficients respectively applied to the first sub voltage parameter and the second sub voltage parameter may correspond to the same value or different values, and are not limited to a specific example. The amplification coefficients may be applied such that the first sub voltage parameter and the second sub voltage parameter fall within a preset range, and for example, the amplification coefficients may be, but not limited to, coefficients such that the first sub voltage parameter and the second sub voltage parameter are positive integers.

The processor 120 may detect whether each of the plurality of battery cells 11, 12, 13, and 14 is abnormal, based on the calculated first voltage parameter. According to an embodiment, the processor 120 may detect abnormality of the plurality of battery cells 11, 12, 13, and 14 based on a result of comparing a product of the first voltage parameter calculated in each of the plurality of time windows and the second voltage profile value of each of the plurality of battery cells 11, 12, 13, and 14 in a corresponding time window with a preset first reference value.

According to an embodiment, when the product of the second voltage profile value of each of the plurality of battery cells 11, 12, 13, and 14 in each of the plurality of time windows and the first voltage parameter is greater than a first reference value, the processor 120 may diagnose that tab disconnection occurs in the battery cell, and when the product of the second voltage profile value of each of the plurality of battery cells 11, 12, 13, and 14 in each of the plurality of time windows and the first voltage parameter is less than the first reference value, the processor 120 may diagnose that an abnormal behavior occurs in the battery cell due to polarization, but the present disclosure is not limited thereto.

The processor 120 may calculate a third sub voltage parameter and a fourth sub voltage parameter for calculating the second voltage parameter. Herein, the third sub voltage parameter may include data corresponding to the nth maximum value (n is an integer of at least 2) among the plurality of second voltage profile values in each of the plurality of time windows, and fourth sub voltage parameter may include data corresponding to the minimum value among the plurality of second voltage profile values in each of the plurality of time windows, but the present disclosure is not limited thereto. Hereinbelow, for convenience, a description will be made assuming that n is 2.

For example, when the second voltage profile value of the first battery cell 11 is the second maximum value and the second voltage profile value of the fourth battery cell 11 is the minimum value in the first time window among the plurality of time windows, the processor 120 may determine the second voltage profile value of the first battery cell 11 in the first time window as a third sub voltage parameter and determine the second voltage profile value of the fourth battery cell 11 in the first time window as a fourth sub voltage parameter. This process may be repeated until the third sub voltage parameter and the fourth sub voltage parameter corresponding to each of the plurality of time windows are determined.

The processor 120 may calculate the second voltage parameter based on the obtained third sub voltage parameter and fourth sub voltage parameter. According to an embodiment, the second sub voltage parameter may include data related to a ratio of a difference between the second voltage profile value and the fourth sub voltage parameter for each of the plurality of battery cells 11, 12, 13, and 14 with respect to a difference between the third sub voltage parameter and the fourth sub voltage parameter in each of the plurality of time windows.

Specifically, the second voltage parameter may be calculated based on Equation 1.

【Equation 1】

$$Second\ Voltage\ Parameter = \frac{V_2(T) - Min(T)}{max\big(M, (N(T) - Min(T))\big)}$$

(Herein, $V_2(T)$ corresponds to a second voltage profile value in a time window T, $Min(T)$ corresponds to a fourth sub voltage parameter in the time window T, $N(T)$ corresponds to a third sub voltage parameter in the time window T, and $M$ corresponds to a preset threshold value.)

According to an embodiment, a function max(a, b) may output the greater value between a and b input to the function. Thus, the second voltage parameter may output the greater value between a preset threshold value M and ($N(T)$ - $Min(T)$). This is because the second voltage parameter may diverge infinitely when ($N(T)$ - $Min(T)$) decreases. The preset threshold value may prevent the second voltage parameter from diverging and allow abnormality of the plurality of battery cells 11, 12, 13, and 14 to be detected. Herein, M is not limited to a specific value and may be set to have various values according to designing.

The processor 120 may detect whether each of the plurality of battery cells 11, 12, 13, and 14 is abnormal, based on the calculated second voltage parameter. According to an embodiment, the processor 120 may detect abnormality of each of the plurality of battery cells 11, 12, 13, and 14, based on a result of comparing the second voltage parameter calculated in each of the plurality of time windows with a preset second reference value.

According to an embodiment, when the second voltage parameter of each of the plurality of battery cells 11, 12, 13, and 14 in each of the plurality of time windows is greater than a preset second reference value, the processor 120 may diagnose that tab disconnection occurs in the battery cell, and when the second voltage parameter of each of the plurality of battery cells 11, 12, 13, and 14 in each of the plurality of time windows is less than the second reference value, the processor 120 may diagnose that an abnormal behavior occurs in the battery cell due to polarization, but the present disclosure is not limited thereto. Herein, the first reference value and the second reference value described above are not limited to a specific example and may be set and changed to have various values.

According to an embodiment, the processor 120 may consider at least one of the first voltage parameter and the second voltage parameter to detect abnormality of the plurality of battery cells 11, 12, 13, and 14. For example, the processor 120 may diagnose that tab disconnection occurs in the battery cell 11, 12, 13, or 14 when a product of the first voltage parameter and the second voltage profile value is greater than or equal to a preset first reference value, when the second voltage parameter is greater than or equal to the preset second reference value, and/or the product of the first voltage parameter and the second voltage profile value is greater than or equal to the preset first reference value and the second voltage parameter is greater than or equal to the preset second reference value.

The memory 130 may store various data for operations of the battery management apparatus 100 (e.g., an instruction, data related to an equation, voltage profiles of a plurality of battery cells, and data related to a reference value). According to an embodiment, the memory 130 may include, but not limited to, a volatile memory device such as static random access memory (SRAM) or dynamic random access memory (DRAM) and a non-volatile memory device such as read only memory (ROM), programable ROM (PROM), and flash memory.

According to an embodiment, the battery management apparatus 100 may be formed integrally with the battery pack 1 (see FIG. 1). In this case, the battery management apparatus 100 may be implemented with, but not limited to, a module battery management system (BMS) for controlling the overall operation of the battery module 10 (see FIG. 1) or a pack BMS for controlling the overall operation of the battery pack 1, etc.

According to an embodiment, the battery management apparatus 100 may be formed separately from the battery pack 1. In this case, the battery management apparatus 100 may be connected to the battery module 10 and/or the battery pack 1 including the same over a wired and/or wireless network, and the battery management apparatus 100 may be implemented with various devices such as a cloud server, a charger, a charger/discharger, etc.

According to an embodiment, the battery management apparatus 100 may transmit a degradation degree (e.g., an SOH, etc.), a diagnosis result, etc., of each of the plurality of battery cells 11, 12, 13, and 14 to an external device (e.g., a cloud server or a user terminal). The cloud server may be configured to provide a degradation degree and/or a diagnosis result of each of the plurality of battery cells 11, 12, 13, and 14 to a plurality of users, and the user terminal may include, but not limited to, a personal computer (PC) or a terminal such as a smartphone.

According to an embodiment, the battery management apparatus 100 may be implemented with a battery swapping station (BSS). Herein, the BSS may be a system that includes a slot into which the battery pack 1 is insertable, and charges the inserted battery pack 1.

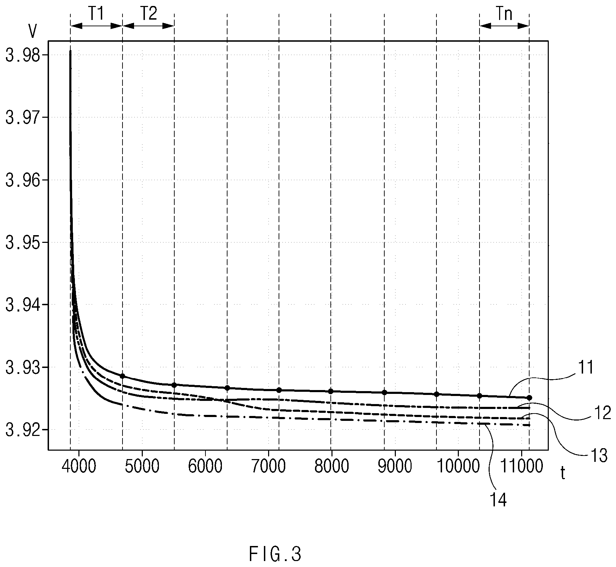

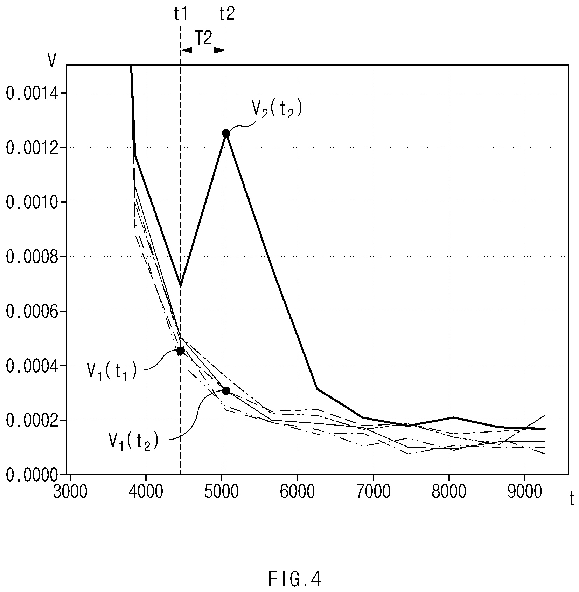

FIG. 3 is a view for describing a first voltage profile according to an embodiment disclosed herein, and FIG. 4 is a view for describing a process of generating a second voltage profile according to an embodiment disclosed herein.

Referring to FIG. 3 first, a plurality of voltage profiles related to a voltage change of each of the plurality of battery cells 11, 12, 13, and 14 (see FIG. 1) over time are shown.

According to an embodiment, in a graph shown in FIG. 3, a horizontal axis indicates time t (sec) and a vertical axis indicates voltage V. For convenience, a description will be made assuming that the plurality of battery cells 11, 12, 13, and 14 are being charged, but the present disclosure is not limited thereto, and the description may also be applied to a battery cell in a discharged state.

After charging of the plurality of battery cells 11, 12, 13, and 14 is completed, each of the plurality of battery cells 11, 12, 13, and 14 enters a rest state. A voltage of each of the plurality of battery cells 11, 12, 13, and 14 may gradually decrease as they enter the rest state, and from a time point after an elapse of about 4000 s, the voltage of each of the plurality of battery cells 11, 12, 13, and 14 may gradually converge to a rest voltage having a small variance.

The processor 120 (see FIG. 2) may divide a voltage profile of each of the plurality of battery cells 11, 12, 13, and 14 into a plurality of time windows. According to an embodiment, the processor 120 may divide a time window from the time point at which each of the plurality of battery cells 11, 12, 13, and 14 enters the rest state into n time windows (n is a positive integer). As shown in FIG. 3, the most preceding time window may be the first time window T1 and the last time window may be the last time window Tn.

According to an embodiment, a length of each of the plurality of time windows T1 to Tn may be identical and/or different.

According to an embodiment, when the length of each of the plurality of time windows T1 to Tn is different, the length of the most preceding time window T1 may be less than the lengths of the other time windows T2 to Tn. This is because a voltage change of the battery cell 11, 12, 13, or 14 entering the rest state is great in a relatively preceding time window. To effectively detect such a voltage change, the processor 120 may set the length of the most preceding time window T1 to be shorter than the lengths of the other time windows. However, this is merely an example, and the processor 120 may set the lengths of the time windows variously such as setting the lengths of a plurality of most preceding time windows to be shorter than the lengths of the other time windows, etc., depending on designing.

According to an embodiment, as described in detail in the detailed description of FIG. 2, the processor 120 may calculate a deviation between an average variance of the voltage of each of the plurality of battery cells 11, 12, 13, and 14 and an average variance of the average voltage of the plurality of battery cells 11, 12, 13, and 14 in each of the plurality of time windows T1 to Tn, and a redundant description will be omitted.

Specifically, referring to FIG. 4, a graph for generating a second voltage profile according to an embodiment disclosed herein is shown. Like in FIG. 3, in a graph shown in FIG. 4, a horizontal axis indicates time t and a vertical axis indicates voltage V.

According to an embodiment, the second time window T2 may be a time window between a time point t1 and a time point t2. The processor 120 (see FIG. 2) may calculate a deviation between the average variance of the voltage of each of the plurality of battery cells 11, 12, 13, and 14 and the average variance of the average voltage of the plurality of battery cells 11, 12, 13, and 14 in each of the second time window T2 and the first time window T1 preceding the second time window T2.

According to an embodiment, the processor 120 may calculate a difference $V2(t2)$ between a deviation $V1(t2)$ calculated in the second time window T2 and a deviation $V1(t1)$ calculated in the first time window T1 preceding the second time window T2. This process may be repeated until the difference is calculated for all of the plurality of time windows.

The processor 120 may generate the second voltage profile based on the difference $V2(t2)$ in each of the plurality of time windows.

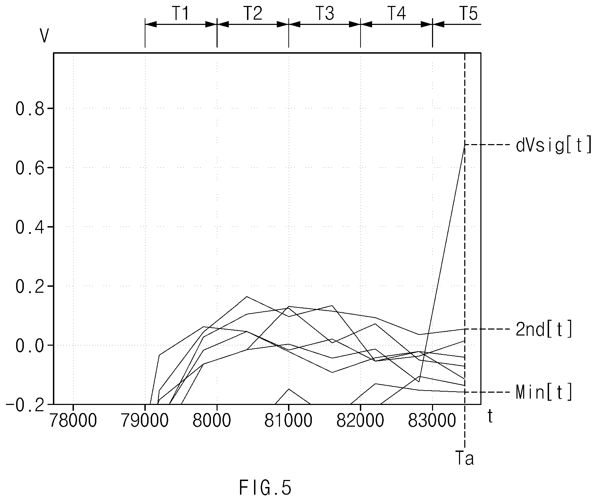

FIG. 5 is a view for describing a second voltage profile according to an embodiment disclosed herein.

According to an embodiment, in a graph shown in FIG. 5, a horizontal axis indicates time t (sec) and a vertical axis indicates voltage V.

The processor 120 (see FIG. 2) may generate the second voltage profile of each of the plurality of battery cells 11, 12, 13, and 14 based on a difference calculated in each of the plurality of time windows T1, T2, T3, and T4 described with reference to FIG. 4. According to an embodiment, $dVsig[t]$ may indicate the second voltage profile, i.e., a difference between a deviation between an average variance of the voltage of each of the plurality of battery cells 11, 12, 13, and 14 and the average variance of the average voltage of the plurality of battery cells 11, 12, 13, and 14 in each of the plurality of time windows T1, T2, T3, and T4 and the deviation between the average variance of the voltage of the first battery cell 11 and the average variance of the average voltage of the plurality of battery cells 11, 12, 13, and 14 in the first time window.

According to an embodiment, the processor 120 may calculate the first voltage parameter for detecting whether the plurality of battery cells 11, 12, 13, and 14 are abnormal based on the second voltage profile of each of the plurality of battery cells 11, 12, 13, and 14, and a redundant description will be omitted.

According to an embodiment, the processor 120 may calculate the second voltage parameter for detecting whether the plurality of battery cells 11, 12, 13, and 14 are abnormal based on the second voltage profile of each of the plurality of battery cells 11, 12, 13, and 14. To this end, the processor 120 may calculate the third sub voltage parameter and the fourth sub voltage parameter based on the second voltage profile of each of the plurality of battery cells 11, 12, 13, and 14.

As described in the description of FIG. 2, to calculate the fourth sub voltage parameter, the processor 120 may obtain data corresponding to the nth maximum value and the minimum value among the plurality of second voltage profile values (n is an integer of at least 2) in each of the plurality of time windows T1, T2, T3, T4, and T5. Hereinbelow, for convenience, the description will be made assuming that n is 2, but the present disclosure is not limited thereto.

For example, when the second voltage profile value of the first battery cell 11 has the second maximum value 2nd [t] in the fifth time window T5 including a time point Ta and the second voltage profile value of the fourth battery cell 11 has the minimum value Min[t], the processor 120 (see FIG. 2) may determine the second voltage profile value of the first battery cell 11 in the fifth time window T5 as the third sub voltage parameter and determine the second voltage profile value of the fourth battery cell 11 in the first time window as the fourth sub voltage parameter.

The processor 120 may calculate the second voltage parameter based on the obtained third sub voltage parameter and fourth sub voltage parameter. According to an embodiment, the second sub voltage parameter may include data related to a ratio of a difference between the second voltage profile value and the fourth sub voltage parameter for each of the plurality of battery cells 11, 12, 13, and 14 with respect to a difference between the third sub voltage parameter and the fourth sub voltage parameter in each of the plurality of time windows, and the second voltage parameter may be calculated based on Equation 1 described above.

A voltage profile of a battery cell until entrance to the rest period after charging/discharging of the battery cell may indicate various behaviors according to a state of the battery cell. The battery management apparatus 100 (see FIG. 1) according to an embodiment disclosed herein may detect an abnormal behavior of a voltage due to a tab disconnection defect of the battery cell and an abnormal behavior of a voltage due to polarization. A voltage change due to voltage inflection has a tendency of instantly rising at the initial stage of the rest period, whereas a voltage change due to polarization has a tendency of continuously dropping in the rest period. The battery management apparatus 100 may appropriately divide a time window in a period having an instant voltage rise to calculate a deviation between voltage parameters in adjacent time windows, thereby effectively detecting an instant voltage change due to polarization.

The battery management apparatus 100 according to an embodiment disclosed herein may detect an abnormal behavior of a voltage of a battery cell due to a subtle voltage change of the battery cell by amplifying the subtle voltage change.

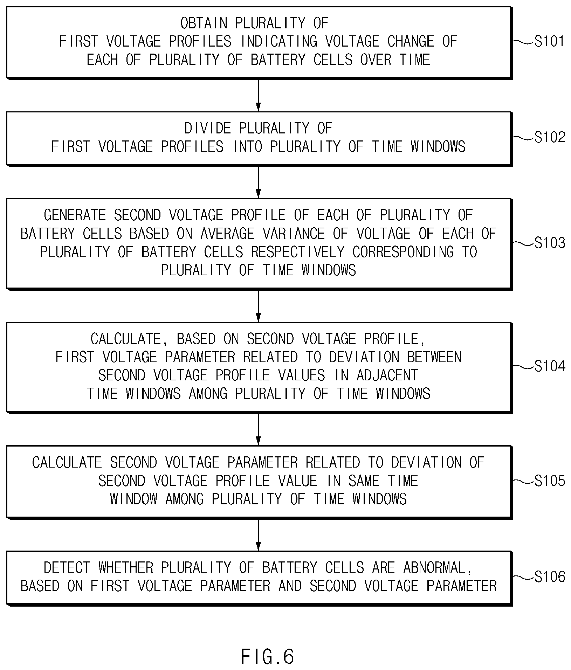

FIG. 6 is a flowchart for describing an operation of a battery management apparatus according to an embodiment disclosed herein.

In operation S101, the battery management apparatus 100 may obtain a plurality of first voltage profiles indicating a voltage change of each of the plurality of battery cells 11, 12, 13, and 14 (see FIG. 1) over time.

In operation S102, the battery management apparatus 100 may divide a plurality of first voltage profiles into a plurality of time windows. According to an embodiment, a length of each of the plurality of time windows may be identical and/or different.

In operation S103, the battery management apparatus 100 may generate a second voltage profile of each of the plurality of battery cells 11, 12, 13, and 14 based on an average variance of the voltage of each of the plurality of battery cells 11, 12, 13, and 14 corresponding to each of the plurality of time windows.

According to an embodiment, the second voltage profile may include data related to, but not limited to, a deviation between average variances of the voltage of each of the plurality of battery cells 11, 12, 13, and 14 in adjacent time windows among the plurality of time windows.

In operation S104, the battery management apparatus 100 may calculate the first voltage parameter related to a deviation between the second voltage profile values in adjacent time windows among the plurality of time windows based on the second voltage profile.

According to an embodiment, an operation of calculating the first voltage parameter may include an operation of calculating the first sub voltage parameter indicating the deviation between the second voltage profile values in adjacent time windows among the plurality of time windows.

According to an embodiment, an operation of calculating the first voltage parameter may include an operation of calculating the second sub voltage parameter indicating the deviation between the averages of the plurality of second voltage profile values in adjacent time windows.

According to an embodiment, an operation of calculating the first voltage parameter may include an operation of calculating the first voltage parameter indicating a deviation between values obtained by amplifying the calculated first sub voltage parameter and second sub voltage parameter.

In operation S105, the battery management apparatus 100 may calculate the second voltage parameter related to the deviation of the second voltage profile value in the same time window among the plurality of time windows.

According to an embodiment, an operation of calculating the second voltage parameter may include an operation of obtaining the third sub voltage parameter corresponding to the nth maximum value among the plurality of second voltage profile values (n is an integer of at least 2) in each of the plurality of time windows.

According to an embodiment, the operation of calculating the second voltage parameter may include an operation of obtaining the fourth sub voltage parameter corresponding to the minimum value among the plurality of second voltage profile values in each of the plurality of time windows.

According to an embodiment, the operation of calculating the second voltage parameter may include an operation of calculating the second voltage parameter indicating a ratio of a difference between the second voltage profile value and the fourth sub voltage parameter with respect to a difference between the third sub voltage parameter and the fourth sub voltage parameter.

According to an embodiment, the second voltage parameter may be calculated based on Equation 1.

In operation S106, the battery management apparatus 100 may detect whether the plurality of battery cells 11, 12, 13, and 14 are abnormal, based on the first voltage parameter and the second voltage parameter.

According to an embodiment, an operation of detecting whether a battery cell is abnormal may include an operation of multiplying the first voltage parameter and the second voltage profile and an operation of detecting abnormality of the battery cell based on a result of comparing a product of the first voltage parameter and the second voltage profile value with the preset first reference value.

According to an embodiment, the operation of detecting whether the battery cell is abnormal may include an operation of detecting whether the battery cell is abnormal based on a result of comparing the second voltage parameter with the preset second reference value.

According to an embodiment, the operation of detecting whether the battery cell is abnormal may consider at least one of the first voltage parameter and the second voltage parameter. For example, the operation of detecting whether the battery cell is abnormal may include any one of an operation of diagnosing that tab disconnection occurs in the battery cell 11, 12, 13, or 14 when the product of the first voltage parameter and the second voltage profile value is greater than or equal to the preset first reference value, an operation of diagnosing that tab disconnection occurs in the battery cell 11, 12, 13, or 14 when the second voltage parameter is greater than or equal to the preset second reference value, and/or an operation of diagnosing that tab disconnection occurs in the battery cell 11, 12, 13, or 14 when the product of the first voltage parameter and the second voltage profile value is greater than or equal to the preset first reference value and the second voltage parameter is greater than or equal to the preset second reference value.

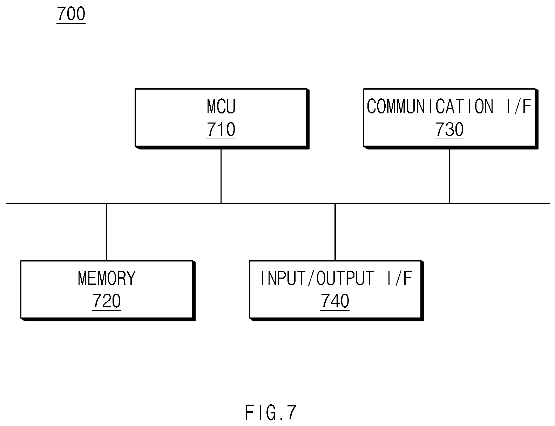

FIG. 7 is a view for describing a computing system having mounted thereon a battery management apparatus according to an embodiment disclosed herein.

Referring to FIG. 7, a computing system 700 may include an MCU 710, a memory 720, an input/output interface (I/F) 730, and a communication I/F 740.

The MCU 710 may be a processor that executes various programs (e.g., a battery cell diagnosis program, etc.) stored in the memory 720, processes various data for detecting abnormality of the plurality of battery cells 11, 12, 13, and 14 (see FIG. 1) through these programs, and causes functions of the battery management apparatus 100 described with reference to FIG. 2 to be performed.

The memory 720 may store various programs for detecting abnormality of a battery cell. The memory 720 may store information about various data generated in a process of detecting abnormality of a battery cell, e.g., a time period length, a deviation, first and second voltage parameters, etc.

The memory 720 may be provided in plural, depending on a need. The memory 720 may be a volatile or nonvolatile memory. For the memory 720 as the volatile memory, random access memory (RAM), dynamic RAM (DRAM), static RAM (SRAM), etc., may be used. For the memory 720 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 720 are merely examples and are not limited thereto.

The input/output I/F 730 may provide an interface for transmitting and receiving data by connecting an input device (not shown) such as a keyboard, a mouse, a touch panel, etc., and an output device such as a display (not shown), etc., with the MCU 710.

The communication I/F 740, which is a component capable of transmitting and receiving various data to and from a server, may be various devices capable of supporting wired or wireless communication. For example, a program for predicting a degradation degree of the battery cell or various data, etc., may be transmitted and received to and from a separately provided external server through the communication I/F 740.

As such, the battery cell abnormality detection method according to an embodiment disclosed herein may be recorded in the memory 720 and executed by the MCU 710.

So far, all components constituting the embodiment have been described as being combined or combined to operate as one, but it is not necessarily limited to this embodiment, and within the scope of the purpose, all components may be selectively combined with one or more components to operate. Moreover, terms such as "include", "constitute" or "have" described above may mean that the corresponding component may be inherent unless otherwise stated, and thus should be construed as further including other components rather than excluding other components.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

[EXPLANATION OF REFERENCE NUMERALS DESIGNATING THE MAJOR ELEMENTS OF THE DRAWINGS]

| 10: | Battery Unit | 11, 12, 13, 14: | Battery Cell |
|---|---|---|---|
| 100: | Battery Management Apparatus | 110: | Interface |
| 120: | Processor | 130: | Memory |

**Claims**

1.  A battery management apparatus comprising:

    an interface configured to obtain a plurality of first voltage profiles indicating a voltage change of each of a plurality of battery cells over time; and
    a processor configured to:

       divide the first voltage profile into a plurality of time windows and generate a second voltage profile of each of the plurality of battery cells based on an average variance of a voltage of each of the plurality of battery cells corresponding to each of the plurality of time windows; and
       calculate, based on the second voltage profile, a first voltage parameter related to a deviation between second voltage profile values in adjacent time windows among the plurality of time windows and a second voltage parameter related to a deviation of the second voltage profile value in a same time window among the plurality of time windows to detect whether the plurality of battery cells are abnormal.

2.  The battery management apparatus of claim 1, wherein the processor is further configured to:

    calculate a first sub voltage parameter indicating the deviation between the second voltage profile values in the adjacent time windows among the plurality of time windows;
    calculate a second sub voltage parameter indicating a deviation between averages of a plurality of second voltage profile values in the adjacent time windows; and
    calculate the first voltage parameter indicating a deviation between values obtained by amplifying the first sub voltage parameter and the second sub voltage parameter.

3.  The battery management apparatus of claim 2, wherein the processor is further configured to:

    detect abnormality of the battery cell based on a result of comparing a product of the first voltage parameter and the second voltage profile value with a preset first reference value; and
    detect that the battery cell is abnormal when the product of the first voltage parameter and the second voltage profile value is greater than the first reference value.

4.  The battery management apparatus of claim 1, wherein the processor is further configured to:

    obtain a third sub voltage parameter corresponding to an nth maximum value (n is an integer of at least 2) among the plurality of second voltage profile values in each of the plurality of time windows;
    obtain a fourth sub voltage parameter corresponding to a minimum value among the plurality of second voltage profile values in each of the plurality of time windows; and
    calculate the second voltage parameter indicating a ratio of a difference between the second voltage profile value and the fourth sub voltage parameter with respect to a difference between the third sub voltage parameter and the fourth sub voltage parameter.

**5.** The battery management apparatus of claim 4, wherein the second voltage parameter is calculated based on

[Equation]

$$Second\ Voltage\ Parameter = \frac{V_2(T) - Min(T)}{max\big(M, (N(T) - Min(T))\big)}$$

wherein $V_2(T)$ corresponds to a second voltage profile value in a time window T, $Min(T)$ corresponds to a fourth sub voltage parameter in the time window T, $N(T)$ corresponds to a third sub voltage parameter in the time window T, and $M$ corresponds to a preset threshold value.

**6.** The battery management apparatus of claim 5, wherein the processor is further configured to:

detect abnormality of the battery cell based on a result of comparing the second voltage parameter with a preset second reference value; and
detect that the battery cell is abnormal when the second voltage parameter is greater than the second reference value.

**7.** The battery management apparatus of claim 1, wherein the second voltage profile indicates a deviation between average variances of the voltage of each of the plurality of battery cells in adjacent time windows among the plurality of time windows.

**8.** An operating method of a battery management apparatus, the operating method comprising:

obtaining a plurality of first voltage profiles indicating a voltage change of each of a plurality of battery cells over time;
dividing the first voltage profile into a plurality of time windows;
generating a second voltage profile of each of the plurality of battery cells based on an average variance of a voltage of each of the plurality of battery cells corresponding to each of the plurality of time windows;
calculating, based on the second voltage profile, a first voltage parameter related to a deviation between second voltage profile values in adjacent time windows among the plurality of time windows;
calculating a second voltage parameter related to a deviation of the second voltage profile value in a same time window among the plurality of time windows; and
detecting whether the plurality of battery cells are abnormal, based on the first voltage parameter and the second voltage parameter.

**9.** The operating method of claim 8, wherein the second voltage profile indicates a deviation between average variances of the voltage of each of the plurality of battery cells in adjacent time windows among the plurality of time windows.

**10.** The operating method of claim 8, wherein the calculating of the first voltage parameter comprises:

calculating a first sub voltage parameter indicating the deviation between the second voltage profile values in the adjacent time windows among the plurality of time windows;
calculating a second sub voltage parameter indicating a deviation between averages of a plurality of second voltage profile values in the adjacent time windows; and
calculating the first voltage parameter indicating a deviation between values obtained by amplifying the first sub voltage parameter and the second sub voltage parameter.

**11.** The operating method of claim 10, wherein the detecting of whether the battery cell is abnormal comprises:

multiplying the first voltage parameter and the second voltage profile value; and
detecting abnormality of the battery cell based on a result of comparing a product of the first voltage parameter and the second voltage profile value with a preset first reference value.

**12.** The operating method of claim 8, wherein the calculating of the second voltage parameter comprises:

obtaining a third sub voltage parameter corresponding to an nth maximum value (n is an integer of at least 2) among the plurality of second voltage profile values in each of the plurality of time windows;
obtaining a fourth sub voltage parameter corresponding to a minimum value among the plurality of second voltage profile values in each of the plurality of time windows; and
calculating the second voltage parameter indicating a ratio of a difference between the second voltage profile value and the fourth sub voltage parameter with respect to a difference between the third sub voltage parameter and the fourth sub voltage parameter.

13. The operating method of claim 12, wherein the second voltage parameter is calculated based on

[Equation]

$$Second\ Voltage\ Parameter = \frac{V_2(T) - Min(T)}{max(M,(N(T) - Min(T)))}$$

wherein $V_2(T)$ corresponds to a second voltage profile value in a time window T, $Min(T)$ corresponds to a fourth sub voltage parameter in the time window T, $N(T)$ corresponds to a third sub voltage parameter in the time window T, and $M$ corresponds to a preset threshold value.

14. The operating method of claim 13, wherein the detecting of abnormality of the battery cell comprises detecting abnormality of the battery cell based on a result of comparing the second voltage parameter with a preset second reference value.

1

BATTERY UNIT
10

BATTERY CELL
11

BATTERY CELL
12

BATTERY CELL
13

BATTERY CELL
14

BATTERY
MANAGEMENT
APPARATUS
100

FIG.1

BATTERY MANAGEMENT APPARATUS
100

INTERFACE
110

PROCESSOR
120

MEMORY
130

FIG.2

FIG.3

FIG.4

FIG.5

```
┌─────────────────────────────────────────────────────┐
│                  OBTAIN PLURALITY OF                │
│  FIRST VOLTAGE PROFILES INDICATING VOLTAGE CHANGE OF │──S101
│     EACH OF PLURALITY OF BATTERY CELLS OVER TIME    │
└─────────────────────────────────────────────────────┘
                          │
                          ▼
┌─────────────────────────────────────────────────────┐
│                  DIVIDE PLURALITY OF                │
│   FIRST VOLTAGE PROFILES INTO PLURALITY OF TIME WINDOWS │──S102
└─────────────────────────────────────────────────────┘
                          │
                          ▼
┌─────────────────────────────────────────────────────┐
│   GENERATE SECOND VOLTAGE PROFILE OF EACH OF PLURALITY OF │
│ BATTERY CELLS BASED ON AVERAGE VARIANCE OF VOLTAGE OF EACH OF │──S103
│   PLURALITY OF BATTERY CELLS RESPECTIVELY CORRESPONDING TO │
│               PLURALITY OF TIME WINDOWS             │
└─────────────────────────────────────────────────────┘
                          │
                          ▼
┌─────────────────────────────────────────────────────┐
│        CALCULATE, BASED ON SECOND VOLTAGE PROFILE,  │
│     FIRST VOLTAGE PARAMETER RELATED TO DEVIATION BETWEEN │──S104
│        SECOND VOLTAGE PROFILE VALUES IN ADJACENT    │
│      TIME WINDOWS AMONG PLURALITY OF TIME WINDOWS   │
└─────────────────────────────────────────────────────┘
                          │
                          ▼
┌─────────────────────────────────────────────────────┐
│  CALCULATE SECOND VOLTAGE PARAMETER RELATED TO DEVIATION OF │
│       SECOND VOLTAGE PROFILE VALUE IN SAME TIME     │──S105
│          WINDOW AMONG PLURALITY OF TIME WINDOWS     │
└─────────────────────────────────────────────────────┘
                          │
                          ▼
┌─────────────────────────────────────────────────────┐
│  DETECT WHETHER PLURALITY OF BATTERY CELLS ARE ABNORMAL, │──S106
│ BASED ON FIRST VOLTAGE PARAMETER AND SECOND VOLTAGE PARAMETER │
└─────────────────────────────────────────────────────┘
```

FIG.6

700

```
┌─────────────────────┐     ┌─────────────────────────┐
│        MCU          │     │  COMMUNICATION I/F      │
│        710          │     │        730              │
└──────────┬──────────┘     └────────────┬────────────┘
           │                             │
───────────┼──────────────┬──────────────┼────────────
           │              │
┌──────────┴──────────┐  ┌┴──────────────────────┐
│      MEMORY         │  │   INPUT/OUTPUT I/F     │
│       720           │  │        740             │
└─────────────────────┘  └────────────────────────┘
```

FIG.7

## INTERNATIONAL SEARCH REPORT

| International application No. |
| --- |
| **PCT/KR2024/018406** |

| | |
| --- | --- |
| **A.** | **CLASSIFICATION OF SUBJECT MATTER** |

**G01R 31/392**(2019.01)i; **G01R 31/396**(2019.01)i; **G01R 31/382**(2019.01)i; **G01R 31/52**(2020.01)i; **G01R 19/00**(2006.01)i; **G01R 19/165**(2006.01)i; **G01R 19/10**(2006.01)i

According to International Patent Classification (IPC) or to both national classification and IPC

| | |
| --- | --- |
| **B.** | **FIELDS SEARCHED** |

Minimum documentation searched (classification system followed by classification symbols)

G01R 31/392(2019.01); G01R 31/02(2006.01); G01R 31/36(2006.01); G01R 31/3835(2019.01); G01R 31/396(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 이상 검출(abnormality detection), 시구간(time interval), 전압 변화량(voltage variation), 평균(average)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| A | KR 10-2021-0031336 A (LG CHEM, LTD.) 19 March 2021 (2021-03-19)<br>See paragraphs [0036]-[0040]; claim 1; and figure 2. | 1-14 |
| A | KR 10-2010-0019249 A (LG CHEM, LTD.) 18 February 2010 (2010-02-18)<br>See paragraphs [0027]-[0062]; and figures 1-5. | 1-14 |
| A | KR 10-2015-0054162 A (LG INNOTEK CO., LTD.) 20 May 2015 (2015-05-20)<br>See paragraphs [0019]-[0039]; and figures 1-4. | 1-14 |
| A | JP 2023-067894 A (SEMICONDUCTOR ENERGY LAB CO., LTD.) 16 May 2023 (2023-05-16)<br>See paragraphs [0074]-[0163]; and figures 1-7. | 1-14 |
| A | US 2017-0108552 A1 (CALIFORNIA INSTITUTE OF TECHNOLOGY) 20 April 2017 (2017-04-20)<br>See paragraphs [0009]-[0091]. | 1-14 |

| | |
| --- | --- |
| ☐ Further documents are listed in the continuation of Box C. | ☑ See patent family annex. |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **27 February 2025** | **27 February 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/018406**

| Patent document cited in search report | | | Publication date (day/month/year) | Patent family member(s) | | | Publication date (day/month/year) |
|---|---|---|---|---|---|---|---|
| KR | 10-2021-0031336 | A | 19 March 2021 | CN | 113811781 | A | 17 December 2021 |
| | | | | CN | 113811781 | B | 04 June 2024 |
| | | | | EP | 3958006 | A1 | 23 February 2022 |
| | | | | EP | 3958006 | A4 | 01 June 2022 |
| | | | | EP | 3958006 | B1 | 29 May 2024 |
| | | | | ES | 2986194 | T3 | 08 November 2024 |
| | | | | JP | 2022-532105 | A | 13 July 2022 |
| | | | | JP | 7621274 | B2 | 24 January 2025 |
| | | | | KR | 10-2715869 | B1 | 14 October 2024 |
| | | | | US | 11965936 | B2 | 23 April 2024 |
| | | | | US | 2022-0229122 | A1 | 21 July 2022 |
| | | | | WO | 2021-049753 | A1 | 18 March 2021 |
| KR | 10-2010-0019249 | A | 18 February 2010 | BR | PI0912066 | A2 | 05 January 2016 |
| | | | | BR | PI0912066 | B1 | 08 October 2019 |
| | | | | CN | 102119338 | A | 06 July 2011 |
| | | | | CN | 102119338 | B | 21 August 2013 |
| | | | | EP | 2321663 | A1 | 18 May 2011 |
| | | | | EP | 2321663 | A4 | 13 November 2013 |
| | | | | EP | 2321663 | B1 | 27 May 2015 |
| | | | | JP | 2011-530696 | A | 22 December 2011 |
| | | | | JP | 5269994 | B2 | 21 August 2013 |
| | | | | KR | 10-0970841 | B1 | 16 July 2010 |
| | | | | TW | I381182 | B | 01 January 2013 |
| | | | | TW | 201007190 | A | 16 February 2010 |
| | | | | US | 2010-0036626 | A1 | 11 February 2010 |
| | | | | US | 2012-0035873 | A1 | 09 February 2012 |
| | | | | US | 8046181 | B2 | 25 October 2011 |
| | | | | US | 8332169 | B2 | 11 December 2012 |
| | | | | WO | 2010-016647 | A1 | 11 February 2010 |
| KR | 10-2015-0054162 | A | 20 May 2015 | KR | 10-2085856 | B1 | 09 March 2020 |
| JP | 2023-067894 | A | 16 May 2023 | CN | 111542759 | A | 14 August 2020 |
| | | | | CN | 111542759 | B | 09 February 2024 |
| | | | | DE | 112018006835 | T5 | 15 October 2020 |
| | | | | JP | 2024-100785 | A | 26 July 2024 |
| | | | | JP | 7234140 | B2 | 07 March 2023 |
| | | | | JP | 7483078 | B2 | 14 May 2024 |
| | | | | KR | 10-2020-0107987 | A | 16 September 2020 |
| | | | | TW | I814765 | B | 11 September 2023 |
| | | | | TW | I856802 | B | 21 September 2024 |
| | | | | TW | 201930910 | A | 01 August 2019 |
| | | | | TW | 202349010 | A | 16 December 2023 |
| | | | | US | 2020-0355749 | A1 | 12 November 2020 |
| | | | | US | 2024-0118344 | A1 | 11 April 2024 |
| | | | | WO | 2019-138286 | A1 | 18 July 2019 |
| US | 2017-0108552 | A1 | 20 April 2017 | EP | 3356836 | A1 | 08 August 2018 |
| | | | | EP | 3356836 | A4 | 01 May 2019 |
| | | | | EP | 3356836 | B1 | 29 June 2022 |
| | | | | EP | 4083640 | A1 | 02 November 2022 |
| | | | | US | 10330732 | B2 | 25 June 2019 |
| | | | | US | 11073564 | B2 | 27 July 2021 |

Form PCT/ISA/210 (patent family annex) (July 2022)

**INTERNATIONAL SEARCH REPORT**
Information on patent family members

International application No.

**PCT/KR2024/018406**

| Patent document cited in search report | Publication date (day/month/year) | Patent family member(s) | | | Publication date (day/month/year) |
|---|---|---|---|---|---|
| | | US | 11567134 | B2 | 31 January 2023 |
| | | US | 2020-0041569 | A1 | 06 February 2020 |
| | | US | 2021-0293889 | A1 | 23 September 2021 |
| | | US | 2023-0324461 | A1 | 12 October 2023 |
| | | WO | 2017-059351 | A1 | 06 April 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240057663